# EUROPÄISCHE PATENTANMELDUNG

(11) **EP 0 602 415 A1**
(43) Veröffentlichungstag der Anmeldung: **22.06.1994**
(21) Anmeldenummer: 93118849.4
(22) Anmeldetag: 24.11.1993
(51) Int. Cl.: B65G 1/06, B65G 65/00, H05K 13/00

(54) **Einrichtung für das Be- und Entladen bei der Behandlung von plattenförmigen Gegenständen**

(30) Priorität: 17.12.1992 DE 4242763
(71) Anmelder: Gebr. Schmid GmbH & Co., D-72250 Freudenstadt (DE)
(72) Erfinder: Schmid, Dieter C., Dipl.-Ing., D-72250 Freudenstadt (DE)
(74) Vertreter: Patentanwälte Ruff, Beier, Schöndorf und Mütschele

(57) **Zusammenfassung**

Bei einer Einrichtung (1) für das Beladen und Entladen bei der Behandlung von plattenförmigen Gegenständen, insbesondere von Leiterplatten und Formätzteilen, die mindestens eine Kassette (2), welche mindestens einen Speicherplatz (3) zur Aufnahme mindestens eines plattenförmigen Gegenstandes aufweist, und Transportmittel zur Positionierung mindestens eines Gegenstandes an dem Speicherplatz besitzt, sind die Transportmittel dem Speicherplatz zugeordnet. Vorzugsweise sind jedem Speicherplatz einzeln antreibbare Transportmittel zugeordnet. Dabei ist der Speicherplatz insbesondere zur Ankupplung eines Antriebs, der beispielsweise einen Antriebsmotor aufweist, ausgebildet. Die Transportmittel können dabei mindestens eine Welle (4) aufweisen, an die der Antrieb ankuppelbar ist. Die Ankupplung erfolgt dabei insbesondere über zwei Rollen, die an der Welle des Speicherplatzes angreifen, wobei eine der beiden Rollen über den Antrieb antreibbar ist.

## Beschreibung

Die Erfindung betrifft eine Einrichtung mit den Merkmalen gemäß Oberbegriff des Anspruchs 1.

Bei der Behandlung von plattenförmigen Gegenständen, insbesondere von Leiterplatten und Formätzteilen, stellt sich das Problem, diese Gegenstände vor Beginn der Behandlung, Zwischen den einzelnen Verfahrensschritten und nach Beendigung der Behandlung in geeigneter Weise zu lagern. Die für eine solche Lagerung vorgesehenen Einrichtungen sollen dabei einerseits eine sichere Lagerung der Gegenstände gewährleisten, andererseits aber ein schnelles Be- und Entladen ermöglichen, um gegebenenfalls Zeitverluste im Produktionsbetrieb zu vermeiden.

Bekannte Einrichtungen enthalten Kassetten oder Magazine mit einer Vielzahl einzelner Speicherplätze, die meist jeweils einen plattenförmigen Gegenstand aufnehmen können. Nach dem Stand der Technik werden die plattenförmigen Gegenstände in diese Kassetten mit einem Bandausleger eingeführt, der kammartig in die einzelnen Speicherplätze (Fächer) eingreift. Bei Verwendung solcher Einrichtungen muß die Platte meist umgekehrt wieder herausgenommen werden, und oft ist auch nur eine bestimmte Folge für das Be- und Entladen möglich. Hinzu kommt, daß durch die Verwendung von Stäben bei dieser Be- und Entladeart die plattenförmigen Gegenstände leicht verkratzt werden. Dies ist gerade bei hochempfindlichen Gegenständen, wie Leiterplatten und Formätzteilen, nicht akzeptierbar.

Die Erfindung stellt sich die Aufgabe, eine Belade- und Entlade-Einrichtung zur Verfügung zu stellen, die die beschriebenen Nachteile vermeidet. Die plattenförmigen Gegenstände sollen schnell und zuverlässig in die Kassette eingebracht und aus dieser entfernt werden können. Eine Beschädigung dieser plattenförmigen Gegenstände soll möglichst ausgeschlossen werden.

Diese Aufgabe wird gelöst durch die Belade- und Entladeeinrichtung mit den Merkmalen des Anspruchs 1.

Vorzugsweise können jedem Speicherplatz einzeln antreibbare Transportmittel zugeordnet sein. Dadurch sind alle Speicherplätze unabhängig voneinander antreibbar.

In Weiterbildung ist der Speicherplatz zur Ankupplung eines Antriebs ausgebildet. Dieser Antrieb dient dazu, die Transportmittel anzutreiben. Insbesondere sind die dem Speicherplatz zugeordneten Transportmittel zur Ankupplung des Antriebs vorgesehen. Dadurch ist ein direkter Antrieb der Transportmittel möglich.

Bei einer bevorzugten Ausführungsform weisen die Transportmittel mindestens eine Welle auf. Dabei ist es bevorzugt, wenn der Antrieb an diese Welle ankuppelbar ist. Bei Verwendung einer Welle läßt sich ein besonders einfaches Ankuppeln des Antriebs an die Transportmittel und damit an den Speicherplatz erreichen.

Insbesondere sind bei horizontal angeordneten Speicherplätzen zwei Wellen an horizontal gegenüberliegenden Seiten des Speicherplatzes vorgesehen. Diese beiden Wellen sind parallel angeordnet. Auf diese Weise wird erreicht, daß der Speicherplatz von beiden Seiten wahlweise antreibbar und damit be- und entladbar ist. Um ein besonders einfaches Angreifen des Antriebs an den beiden Wellen zu ermöglichen, ragen die beiden Wellen an ihren Enden über die Abmessungen des Speicherplatzes hinaus. Je nach Verwendungszweck können die Wellen an ihren Enden einzeln, paarweise oder an allen Enden über die Abmessungen des Speicherplatzes hinausragen.

In Weiterbildung weisen die Transportmittel mindestens ein Band auf, das zum Auflegen und/oder Fördern der plattenförmigen Gegenstände vorgesehen ist. Bei den bereits beschriebenen Ausführungsformen ist es zweckmäßig, mindestens ein horizontal geführtes Band zwischen zwei parallel angeordneten Wellen vorzusehen, wobei dieses Band als geschlossenes Band über die beiden Wellen geführt ist.

In Weiterbildung weist der Antrieb einen Antriebsmotor, wie beispielsweise einen Elektromotor und gegebenenfalls ein Getriebe auf. Insbesondere besitzt der Antrieb zusätzlich eine Rolle, die zum Antreiben der Transportmittel vorgesehen ist. Es ist bevorzugt, wenn der Antrieb mit Hilfe einer Rolle an den Speicherplatz, insbesondere an die dem Speicherplatz zugeordneten Transportmittel, ankuppelbar ist. Vorzugsweise sind dabei zwei Rollen vorgesehen, die an die Welle des Speicherplatzes ankuppelbar sind und an diese angreifen. Auf diese Weise wird über die beiden Rollen eine Ankupplung des Antriebs an die Transportmittel des Speicherplatzes bewirkt.

Üblicherweise ist es ausreichend, wenn eine der beiden Rollen über den Antriebsmotor antreibbar ist und auf diese Weise die Welle des Speicherplatzes antreibt. In diesen Fällen dient die zweite Rolle zur Führung der Welle. Die zweite Rolle kann dann zweckmäßig auf der gegenüberliegenden Seite der als Antriebsrolle dienenden Rolle angeordnet sein. Die beiden Rollen und die Welle des Speicherplatzes bestehen zweckmäßig aus Materialien, die eine gute Führung der Welle durch die Rollen und eine gute Übertragung der durch die Antriebsrolle auf die Welle aufgebrachten Drehbewegung erlauben. Üblicherweise besteht dabei die Welle aus Metall, und die beiden Rollen bestehen zumindest an ihren Außenflächen aus gummiartigem Material, wie beispielsweise Hartgummi.

Der erfindungsgemäßen Einrichtung kann eine Transportvorrichtung zugeordnet sein, die insbesondere den Antrieb zum Antreiben der Transportmittel enthält. Bei solchen Ausführungsformen sind beispielsweise auch die Rollen, die zur Ankupplung an den Speicherplatz dienen, an dieser Transportvorrichtung angeordnet.

In Weiterbildung kann die Transportvorrichtung Walzen zum An- und Abtransport der plattenförmigen Gegenstände aufweisen. Dabei sind diese Walzen insbesondere horizontal angeordnet, und dies vorzugsweise dann, wenn eine Kassette mit horizontal angeordneten Speicherplätzen verwendet wird. Die Walzen dienen dazu, die plattenförmigen Gegenstände an den Speicherplatz, an dem ein Be- oder Entlade-Vorgang stattfindet, heran zu transportieren oder von diesem weg zu transportieren. Die Walzen können selbst über einen Antriebsmotor, gegebenenfalls über den gleichen, der auch zum Antrieb der Transportmittel vorgesehen ist, angetrieben sein. Es ist jedoch auch möglich, daß es sich lediglich um drehbar gelagerte Walzen handelt, auf die die plattenförmigen Gegenstände bereits mit einer gewissen Anfangsgeschwindigkeit aufgebracht werden.

Weiterhin ist es bevorzugt, wenn der Be- und Entladeeinrichtung ein Sensor zugeordnet ist, wobei insbesondere mit dessen Hilfe die Ankupplung und/oder Betätigung des Antriebs steuerbar ist. Dabei kann der Sensor vorzugsweise an der bereits beschriebenen Transportvorrichtung vorgesehen sein. Der Sensor kann hauptsächlich die Funktion einer sog. Lichtschranke besitzen und dann ein Signal an eine Steuereinrichtung weitergeben, wenn Anfang bzw. Ende eines plattenförmigen Gegenstandes in sein Beobachtungsfeld eintreten bzw. dieses verlassen.

Weiterhin kann der Be- und Entladeeinrichtung eine Hubvorrichtung zugeordnet sein, mit deren Hilfe die Speicherplätze insbesondere taktweise an der zum Beladen oder Entladen vorgesehenen Stelle vorbeiführbar sind.

Die Einrichtung nach der Erfindung hat den Vorteil, daß zwischen dem Speicherplatz und dem plattenförmigen Gegenstand keine Relativbewegung stattfindet. Der plattenförmige Gegenstand wird vom Speicherplatz selbst, d.h. von den Transportmitteln, beispielsweise auf den zwischen den beiden Wellen vorgesehenen Bändern, transportiert. Dadurch wird ausgeschlossen, daß Beschädigungen, wie beispielsweise Kratzer, an den plattenförmigen Gegenständen entstehen. Dies ist gerade bei empfindlichen Gegenständen, wie beispielsweise Leiterplatten, von großem Vorteil. Dieses schonende Beladen und Entladen ermöglicht es auch, sehr dünne Teile, wie beispielsweise Teile ab 50 µm, mit dem Belade- und Entlade-System nach der Erfindung in den Kassetten zu lagern oder zu magazinieren.

Die Erfindung hat weiterhin den Vorteil, daß ein Beladen und Entladen von beiden Seiten einer Kassette mit horizontal angeordneten Speicherplätzen möglich ist. Es ist nicht erforderlich, die plattenförmigen Gegenstände wieder auf der Seite zu entnehmen, von der sie in den Speicherplatz eingebracht wurden. Außerdem ist ein Beladen und Entladen in beliebiger Reihenfolge möglich. Es kann auch daran gedacht werden, plattenförmige Gegenstände von beiden Seiten gleichzeitig und/oder in einer gesteuerten Reihenfolge zu entnehmen, so daß beispielsweise verschiedene plattenförmige Gegenstände gelagert und selektiv wieder entnommen werden können. Zu diesem Zweck kann die Einrichtung mit einer geeigneten Steuerung versehen oder in den Steuerungsablauf einer Gesamtanlage integriert sein.

Weiterhin betrifft die Erfindung eine Kassette für das Beladen und Entladen plattenförmiger Gegenstände, insbesondere von Leiterplatten und Formätzteilen, mit mindestens einem Speicherplatz zur Aufnahme mindestens eines plattenförmigen Gegenstandes. Nach der Erfindung ist diese Kassette dadurch gekennzeichnet, daß dem Speicherplatz Transportmittel zur Positionierung mindestens eines Gegenstandes an dem Speicherplatz zugeordnet sind, wobei insbesondere jedem Speicherplatz einzeln antreibbare Transportmittel zugeordnet sind. Dabei kann der Speicherplatz, insbesondere die dem Speicherplatz zugeordneten Transportmittel, zur Ankupplung eines Antriebs zum Antreiben der Transportmittel ausgebildet sein. In Weiterbildung weisen die Transportmittel mindestens eine Welle auf, an die insbesondere der Antrieb ankuppelbar ist. Vorzugsweise ist an zwei horizontal gegenüberliegenden Seiten des Speicherplatzes in paralleler Anordnung jeweils eine Welle vorgesehen, wobei insbesondere ein oder beide Enden der Wellen mindestens an einer Seite, vorzugsweise an beiden Seiten über die Abmessungen des Speicherplatzes hinausragen. Schließlich betrifft die Erfindung ein Verfahren zum Beladen und Entladen plattenförmiger Gegenstände, insbesondere von Leiterplatten und Formätzteilen, mit einer in der Beschreibung bereits dargestellten Einrichtung oder Kassette. Dieses Verfahren ist nach der Erfindung so ausgestaltet, daß mindestens ein plattenförmiger Gegenstand in einen Speicherplatz horizontal eingebracht oder aus diesem entfernt wird. Dabei wird insbesondere in jeden Speicherplatz ein plattenförmiger Gegenstand eingebracht oder aus diesem entfernt.

Bei dem erfindungsgemäßen Verfahren werden insbesondere nacheinander die folgenden Verfahrensschritte durchgeführt:
- Heranführen des Speicherplatzes an die Stelle, an der der plattenförmige Gegenstand be- oder entladen werden soll, insbesondere mit Hilfe einer taktweise bewegten Hubvorrichtung,
- Ankuppeln eines Antriebes an am Speicherplatz vorgesehene Transportmittel, insbesondere durch Angreifen zweier Rollen an eine am Speicherplatz vorgesehene Welle,
- Einschalten des Antriebs zum Be- oder Entladen des Speicherplatzes, insbesondere mit Hilfe eines zur Steuerung des Antriebs vorhandenen Sensors,
- Abschalten des Antriebs nach erfolgtem Be- oder Entladen, insbesondere mit Hilfe des Sensors,
- Abkuppeln des Antriebs vom Speicherplatz und
- Weiterbewegung des Speicherplatzes und ggf. Heranführen des nächsten Speicherplatzes.

Die beschriebenen Merkmale und weitere Merkmale der Erfindung ergeben sich aus der nachfolgenden Beschreibung von bevorzugten Ausführungsformen in Verbindung mit den Unteransprüchen und den Zeichnungen. Hierbei können die einzelnen Merkmale jeweils für sich oder zu mehreren in Kombination miteinander verwirklicht sein.

In den Zeichnungen zeigen:
- Fig. 1: eine Seitenansicht einer erfindungsgemäßen Belade- und Entladeeinrichtung,
- Fig. 2: eine Draufsicht auf die in Fig. 1 dargestellte Einrichtung,
- Fig. 3: eine teilweise im Schnitt dargestellte Ansicht der Einrichtung nach Fig. 1, aus dem in Fig. 1 mit einem Kreis X umgrenzten Bereich, und
- Fig. 4: eine teilweise im Schnitt dargestellte Ansicht der Einrichtung nach Fig. 2, aus dem in Fig. 2 mit einem Kreis Y umgrenzten Bereich.

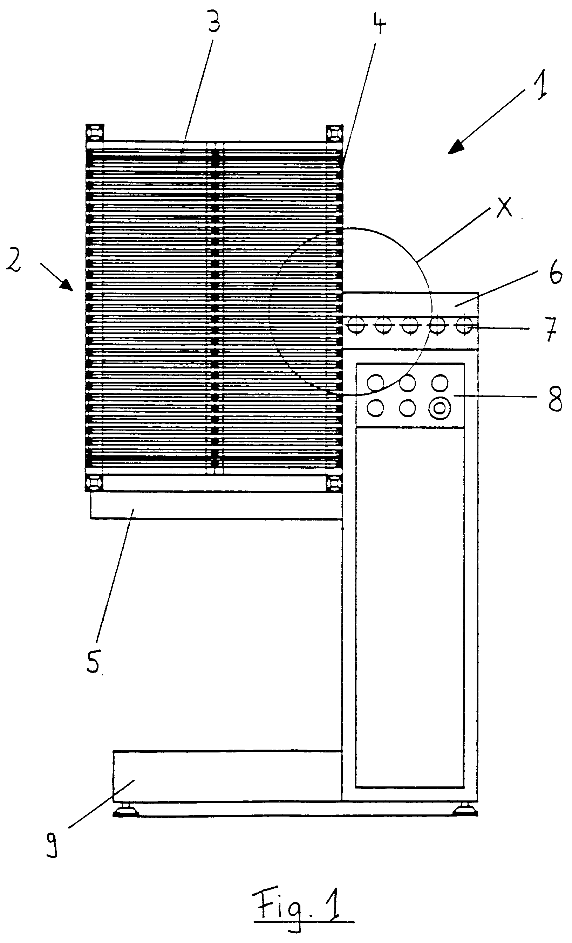

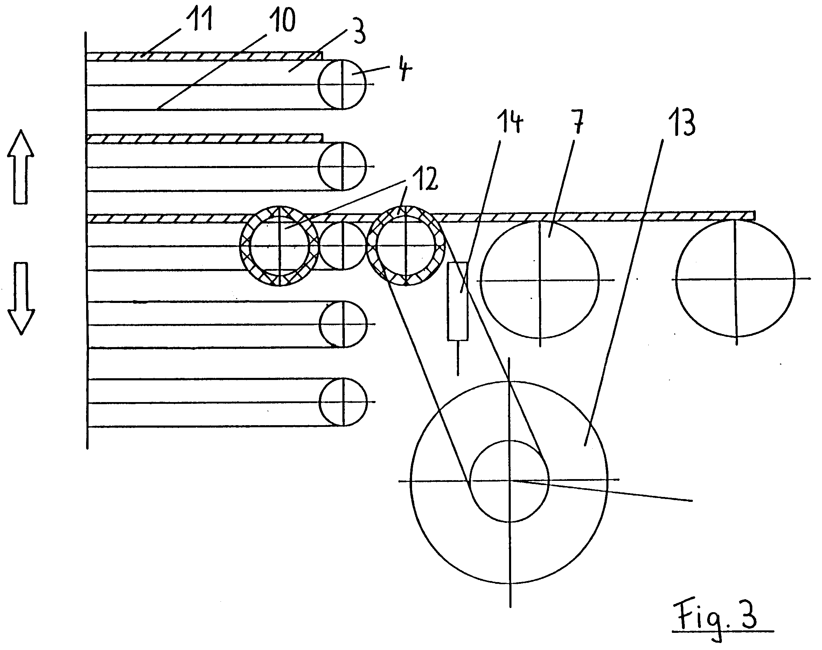

Die in Fig. 1 dargestellte Belade- und Entladeeinrichtung 1 weist eine Kassette 2 mit einer Vielzahl horizontal angeordneter Speicherplätze 3 auf. Jeder dieser Speicherplätze 3 besitzt an zwei gegenüberliegenden Enden jeweils eine Welle 4 als Transportmittel. Die Kassette 2 ist auf einer in Form einer Hubgabel ausgebildeten Hubvorrichtung 5 gelagert und mit Hilfe dieser Hubvorrichtung 5 taktweise vertikal bewegbar. Fig. 1 zeigt außerdem eine Transportvorrichtung 6 mit mehreren horizontal angeordneten Walzen 7. Weiterhin ist noch eine Steuereinrichtung 8 und ein Fußteil 9, das der Einrichtung 1 die notwendige Stabilität gibt, gezeigt. Der durch den Kreis umschlossene Bereich X ist in Fig. 3 ausführlicher dargestellt.

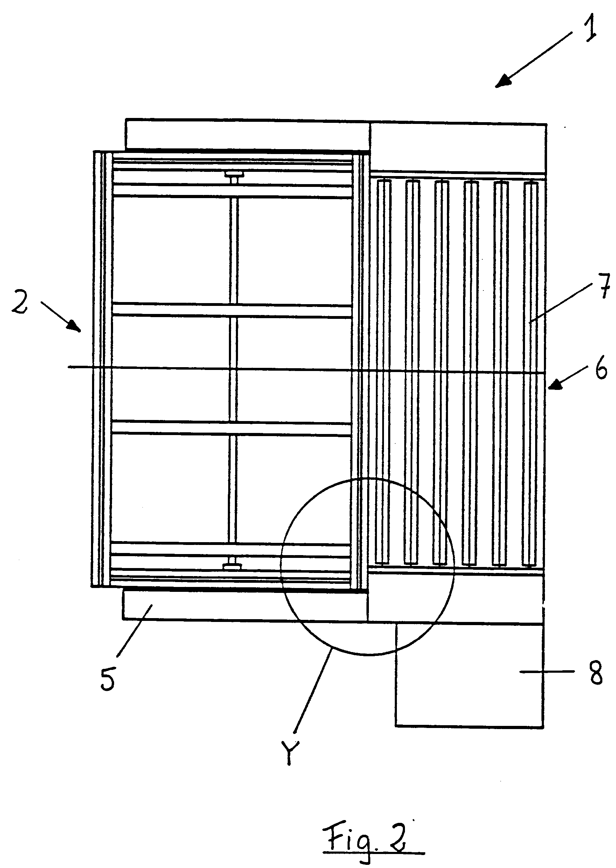

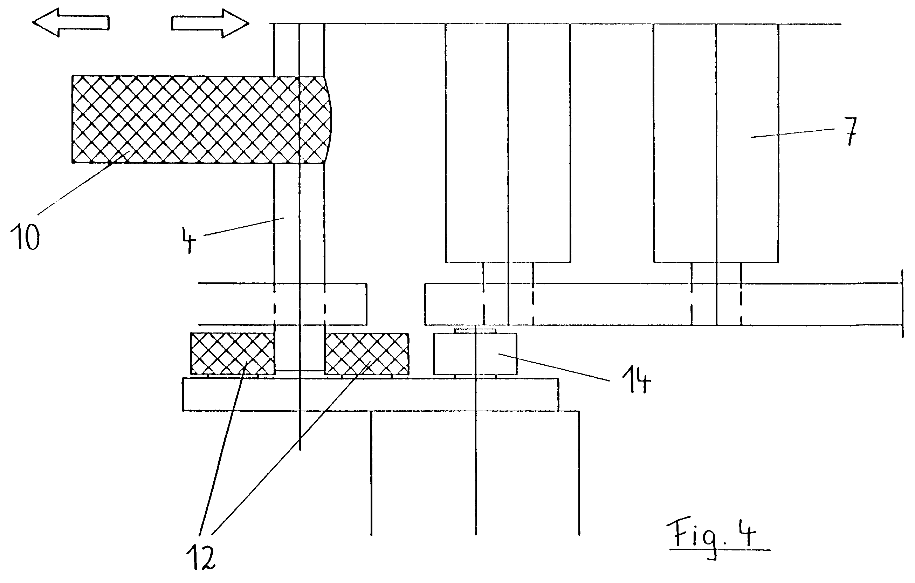

Fig. 2 zeigt die in Fig. 1 dargestellte Einrichtung 1 in Draufsicht. Von der Kassette 2 ist aus Übersichtlichkeitsgründen nur der oberste Speicherplatz zu sehen. Weiterhin sind die Transportvorrichtung 6 mit den Walzen 7, die Steuereinrichtung 8 und die überstehenden Enden der als Hubgabel ausgebildeten Hubvorrichtung 5 zu erkennen. Der von dem mit Y gekennzeichneten Kreis umfaßte Bereich ist in Fig. 4 ausführlicher dargestellt.

Fig. 3 zeigt einen Teil des in Fig. 1 vom Kreis X umfaßten Bereichs. Die fünf dargestellten Speicherplätze 3 besitzen an ihrem Ende jeweils eine Welle 4. Über diese Welle 4 und eine in Fig. 3 nicht dargestellte entsprechende Welle am anderen Ende des Speicherplatzes sind jeweils Bänder 10 zur Auflage und zum Transport von plattenförmigen Gegenständen 11 gelegt. Die beiden Wellen 4 und die Bänder 10 stellen die Transportmittel der Speicherplätze 3 dar.

In Fig. 3 sind in die oberen beiden Speicherplätze 3 plattenförmige Gegenstände 11 in Form von Leiterplatten eingelegt. Der mittlere Speicherplatz 3 ist in dem Zustand dargestellt, bei dem ein plattenförmiger Gegenstand 11 in Form einer Leiterplatte in den entsprechenden Speicherplatz 3 eingebracht oder aus diesem entfernt wird.

So zeigt Fig. 3 zwei Rollen 12, die an der Welle 4 des mittleren Speicherplatzes 3 angreifen. Dabei sind die beiden Rollen 12 an einander gegenüberliegenden Seiten der Welle 4 angeordnet, um eine ausreichende Führung der Welle 4 und eine Übertragung der Drehbewegung der rechten Rolle 12 auf die Welle 4 zu gewährleisten. Um die rechte Rolle 12 anzutreiben, ist diese mit einem Antriebsmotor 13 verbunden. Dieser Antriebsmotor 13 und die Verbindung dieses Motors 13 mit der rechten Rolle 12 ist in Fig. 3 nur schematisch dargestellt. Rollen 12, Antriebsmotor 13 und die Verbindung (Getriebe) des Motors 13 mit den Rollen 12 stellen den Antrieb der Einrichtung 1 dar.

Weiter zeigt Fig. 3 Walzen 7, die zum An- oder Abtransport der plattenförmigen Gegenstände 11 dienen. Weiter ist in Fig. 3 noch ein Sensor 14 angedeutet, der dazu dient, zu erkennen, wann der Anfang oder das Ende eines plattenförmigen Gegenstandes 11 an ihm vorbei gelaufen ist. Mit Hilfe dieses Sensors 14 ist beispielsweise der Antriebsmotor 13 steuerbar, so daß die rechte Rolle 12 dann angetrieben wird, wenn der Plattenförmige Gegenstand 11 beladen oder entladen werden soll und der Antrieb abgeschaltet wird, wenn der Belade- oder Entladevorgang beendet ist.

Fig. 4 zeigt eine Ansicht aus dem in Fig. 2 mit Y bezeichneten Kreis. Dabei sind die beiden Rollen 12 zu erkennen, die auf gegenüberliegenden Seiten an die Welle 4 angreifen. Weiter ist über die Welle 4 ein Band 10 gelegt, das die Welle 4 und die nicht dargestellte, sich auf der gegenüberliegenden Seite des Speicherplatzes 3 befindende Welle miteinander verbindet und zur Auflage und zum Transport der plattenförmigen Gegenstände 11 dient. Weiter sind in Fig. 4 Walzen 7 und der Sensor 14 zu erkennen.

Die in den Figuren dargestellte Belade- und Entladeeinrichtung arbeitet nach dem im Folgenden dargestellten Verfahren:

Die auf der als Hubgabel ausgebildeten Hubvorrichtung 5 stehende Kassette 2 wird taktweise vertikal bewegt, bis der nächste oder ein ausgewählter Speicherplatz an der Belade- und Entladestelle liegt. Diese Stelle befindet sich an der Transportvorrichtung 6 in horizontaler Verlängerung der durch die Walzen 7 gebildeten Transportebene. Sobald sich der entsprechende Speicherplatz 3 an der richtigen Stelle befindet, werden die beiden Rollen 12 und damit der Antrieb an die entsprechende Welle 4 angekuppelt. Soll der angekuppelte Speicherplatz 3 beladen werden, wird der Antriebsmotor 13 eingeschaltet, sobald der Anfang des plattenförmigen Gegenstandes 11 über den Sensor 14 läuft. Der Antriebsmotor 13 wird abgeschaltet, wenn der Sensor 14 das Ende des plattenförmigen Gegenstandes 11 detektiert hat. Soll der entsprechende Speicherplatz 3 entladen werden, wird der Antriebsmotor 13 sofort angeschaltet und dann abgeschaltet, wenn der Sensor 14 das Ende des plattenförmigen Gegenstandes 11 detektiert hat.

Nach beendetem Belade- oder Entladevorgang wird entkuppelt, d.h. die beiden Rollen 12 werden von der entsprechenden Welle 4 entfernt. Anschließend wird die Kassette 2 entweder auf den nächsten, d.h. den nächsten oberen oder nächsten unteren Speicherplatz 3 getaktet oder es wird gezielt ein bestimmter Speicherplatz 3 angefahren, um dort wieder einen entsprechenden Belade- oder Entladevorgang durchzuführen. Der Vorgang wird so lange wiederholt, bis entweder die ganze Kassette 2 gefüllt oder entleert ist oder bis alle selektiv angesteuerten Speicherplätze 3 be- oder entladen sind.

Bei der in Fig. 1 dargestellten Einrichtung muß der Beladevorgang unterbrochen werden, um eine gegebenenfalls volle oder entleerte Kassette 2 auszutauschen. Es ist jedoch möglich, die erfindungsgemäße Einrichtung so auszugestalten, daß ein kontinuierlicher Betrieb möglich ist. Zu diesem Zweck kann bei der in Fig. 1 dargestellten Einrichtung 1 automatisch eine zweite Kassette 2 von unten nachgeführt und die bereits bearbeitete Kassette 2 oben entnommen werden. Selbstverständlich ist es auch möglich, eine bearbeitete Kassette unten zu entnehmen und die nächste Kassette von oben nachzuführen.

Es ist auch möglich, mehrere Belade- oder Entladeeinrichtungen hintereinander oder parallel zu schalten. Eine Anordnung mit zwei parallelen Ladestationen kann beispielsweise dadurch realisiert werden, daß die beiden nebeneinander angeordneten Ladestationen über einen sog. L-Verteiler bedient werden. Solche Ausführungsformen sind selbstverständlich nicht auf die Verwendung von nur zwei Ladestationen beschränkt. Eine Vielzahl von Ladestationen kann nebeneinander angeordnet sein, und diese können wahlweise, ggf. über eine Computersteuerung, bedient werden.

Die Belade- und Entladeeinrichtung gemäß der Erfindung ist für sämtliche anfallenden Lagerprobleme bei der Behandlung von plattenförmigen Gegenständen, insbesondere von Leiterplatten und Formätzteilen, geeignet. Die Einrichtungen können sowohl zur Zwischenlagerung als auch zur Endlagerung der Gegenstände verwendet werden. Die Anzahl der Speicherplätze, die sich in einer Kassette befinden, kann frei gewählt werden. Es ist auch möglich, mehrere plattenförmige Gegenstände innerhalb eines Speicherplatzes zu lagern.

## Patentansprüche

1. Einrichtung für das Beladen und Entladen bei der Behandlung von plattenförmigen Gegenständen (11), insbesondere von Leiterplatten und Formätzteilen, mit mindestens einer Kassette (2), die mindestens einen Speicherplatz (3) zur Aufnahme mindestens eines plattenförmigen Gegenstandes (11) aufweist und mit Transportmitteln zur Positionierung mindestens eines Gegenstandes (11) an dem Speicherplatz (3), dadurch gekennzeichnet, daß die Transportmittel dem Speicherplatz (3) zugeordnet sind.

2. Einrichtung nach Anspruch 1, dadurch gekennzeichnet, daß jedem Speicherplatz (3) einzeln antreibbare Transportmittel zugeordnet sind.

3. Einrichtung nach Anspruch 1 oder 2, dadurch gekennzeichnet, daß der Speicherplatz (3) insbesondere die dem Speicherplatz (3) zugeordneten Transportmittel zur Ankupplung eines Antriebs zum Antreiben der Transportmittel ausgebildet ist.

4. Einrichtung nach einem der vorhergehenden Ansprüche, dadurch gekennzeichnet, daß die Transportmittel mindestens eine Welle (4) aufweisen, wobei insbesondere der Antrieb an die Welle (4) ankuppelbar ist.

5. Einrichtung nach Anspruch 4, dadurch gekennzeichnet, daß an zwei horizontal gegenüberliegenden Seiten des Speicherplatzes (3) in paralleler Anordnung jeweils eine Welle (4) vorgesehen ist, wobei insbesondere ein oder beide Enden der Wellen (4) mindestens an einer Seite, vorzugsweise an beiden Seiten über die Abmessungen des Speicherplatzes (3) hinausragen.

6. Einrichtung nach einem der vorhergehenden Ansprüche, dadurch gekennzeichnet, daß die Transportmittel mindestens ein Band (10) aufweisen, wobei insbesondere zwischen zwei parallel angeordneten Wellen (4) mindestens ein horizontal geführtes Band (10) zum Auflegen und/oder Fördern der plattenförmigen Gegenstände (11) vorgesehen ist.

7. Einrichtung nach Anspruch 3 bis 6, dadurch gekennzeichnet, daß der Antrieb einen Antriebsmotor (13) und gegebenenfalls ein Getriebe aufweist.

8. Einrichtung nach einem der Ansprüche 3 bis 7, dadurch gekennzeichnet, daß der Antrieb mindestens eine Rolle (12) zum Antreiben der Transportmittel aufweist, wobei insbesondere der Antrieb mit Hilfe mindestens einer Rolle (12) an den Speicherplatz (3) ankuppelbar ist.

9. Einrichtung nach Anspruch 8, dadurch gekennzeichnet, daß zwei Rollen (12) an der Welle (4) des Speicherplatzes (3) ankuppelbar sind, wobei insbesondere eine der beiden Rollen (12) über den Antriebsmotor (13) antreibbar ist.

10. Einrichtung nach einem der vorhergehenden Ansprüche, dadurch gekennzeichnet, daß der Einrichtung eine Transportvorrichtung (6) zugeordnet ist, die insbesondere den Antrieb zum Antreiben der Transportmittel aufweist.

11. Einrichtung nach Anspruch 10, dadurch gekennzeichnet, daß die Transportvorrichtung (6) insbesondere horizontal angeordnete Walzen (7) zum An- und Abtransport der plattenförmigen Gegenstände (11) aufweist.

12. Einrichtung nach einem der vorhergehenden Ansprüche, dadurch gekennzeichnet, daß der Einrichtung ein insbesondere in der Transportvorrichtung (6) vorgesehener Sensor (14) zugeordnet ist, wobei insbesondere mit dessen Hilfe die Ankupplung und/oder Betätigung des Antriebs steuerbar ist.

13. Einrichtung nach einem der vorhergehenden Ansprüche, dadurch gekennzeichnet, daß der Einrichtung eine Hubvorrichtung (5) zugeordnet ist, mit deren Hilfe die Speicherplätze (3) taktweise bewegbar, insbesondere taktweise an der Transportvorrichtung (6) vorbeiführbar sind.

14. Kassette zur Aufnahme von plattenförmigen Gegenständen (11), insbesondere von Leiterplatten und Formätzteilen, mit mindestens einem Speicherplatz (3) zur Aufnahme mindestens eines plattenförmigen Gegenstandes (11), dadurch gekennzeichnet, daß dem Speicherplatz Transportmittel zur Positionierung mindestens eines Gegenstandes (11) an dem Speicherplatz (3) zugeordnet sind, wobei insbesondere jedem Speicherplatz (3) einzeln antreibbare Transportmittel zugeordnet sind.

15. Kassette nach Anspruch 14, dadurch gekennzeichnet, daß der Speicherplatz (3), insbesondere die dem Speicherplatz (3) zugeordneten Transportmittel zur Ankupplung eines Antriebs zum Antreiben der Transportmittel ausgebildet ist.

16. Kassette nach Anspruch 14 oder 15, dadurch gekennzeichnet, daß die Transportmittel mindestens eine Welle (4) aufweisen, wobei insbesondere der Antrieb an die Welle (4) ankuppelbar ist.
